(19) Europäisches Patentamt

European Patent Office

Office européen des brevets

(11) **EP 1 477 581 A1**

(12) **EUROPEAN PATENT APPLICATION**

(43) Date of publication:
**17.11.2004 Bulletin 2004/47**

(51) Int Cl.$^7$: **C23C 16/40**, C23C 30/00,
C23C 28/04, C23C 16/02,
B23B 27/14

(21) Application number: **03010542.3**

(22) Date of filing: **10.05.2003**

| | |
|---|---|
| (84) Designated Contracting States:<br>**AT BE BG CH CY CZ DE DK EE ES FI FR GB GR<br>HU IE IT LI LU MC NL PT RO SE SI SK TR**<br>Designated Extension States:<br>**AL LT LV MK**<br><br>(71) Applicant: **SECO TOOLS AB**<br>**S-737 82 Fagersta (SE)** | (72) Inventor: **Ruppi, Sakari**<br>**737 44 Fagersta (SE)**<br><br>(74) Representative: **Taquist, Lennart**<br>**Sandvik AB**<br>**Patent Department**<br>**811 81 Sandviken (SE)** |

(54) **Enhanced alumina layer produced by CVD**

(57) The present invention introduces a new and refined method to produce $\alpha$-$Al_2O_3$ layers with substantially better wear resistance and toughness than the prior art. The $\alpha$-$Al_2O_3$ layer of the present invention is formed on a bonding layer of (Ti,Al)(C,O,N) with increasing aluminium content towards the outer surface. Nucleation of $\alpha$-$Al_2O_3$ is obtained through a nucleation step being composed of both aluminising and oxidisation steps. The $\alpha$-$Al_2O_3$ layer according to this invention has a thickness ranging from 1 to 20 $\mu$m and is composed of columnar grains. The length/width ratio of the alumina grains is from 2 to 12, preferably 5 to 9. The layer is characterised by a strong (012) growth texture, measured using XRD, and by the almost total absence (104), (110), (113) and (116) diffraction peaks.

EP 1 477 581 A1

## Description

The present invention relates to a cutting tool insert for metal machining, having a substrate of cemented carbide, cermet or ceramics on which a hard and wear resistant coating is deposited. The coating is adherently bonded to the substrate and covering all functional parts thereof. The coating is composed of one or more refractory layers of which at least one layer is a strongly textured alpha-alumina ($\alpha$-$Al_2O_3$).

Background of the invention

A crucial step in deposition of different $Al_2O_3$ polymorphs is the nucleation step. $\kappa$-$Al_2O_3$ can be grown in a controlled way on {111} surfaces of TiN, Ti(C,N) or TiC having the fcc structure. TEM has confirmed the growth mode which is that of the close-packed (001) planes of $\kappa$-$Al_2O_3$ on the close-packed {111} planes of the cubic phase with the following epitaxial orientation relationships: $(001)_\kappa$ // $(111)_{TiX}$; $[100]_\kappa$ // $[112]_{TiX}$. An explanation and a model for the CVD growth of metastable $\kappa$-$Al_2O_3$ have proposed earlier (Y. Yoursdshahyan, C. Ruberto, M. Halvarsson, V. Langer, S. Ruppi, U. Rolander and B.I. Lundqvist, Theoretical Structure Determination of a Complex Material: $\kappa$-$Al_2O_3$, *J. Am. Ceram. Soc.* 82(6)(1999)1365-1380).

When properly nucleated $\kappa$-$Al_2O_3$ layers can be grown to a considerable thickness (>10$\mu$m). The growth of even thicker layers of $\kappa$-$Al_2O_3$ can be ensured through re-nucleation on thin layers of, for example TiN, inserted in the growing $\kappa$-$Al_2O_3$ layer. When nucleation is ensured the $\kappa\rightarrow\alpha$ transformation can be avoided during deposition by using a relatively low deposition temperature (<1000 °C). During metal cutting the phase transformation has confirmed to occur. In addition to the phase stability there are several reasons why $\alpha$-$Al_2O_3$ should be preferred in many metal cutting applications. As shown earlier $\alpha$-$Al_2O_3$ exhibits better wear properties in cast iron (US 5,137,774). Further a layer which has been nucleated as $\alpha$-$Al_2O_3$ does not contain any transformation cracks and stresses. Consequently nucleated $\alpha$-$Al_2O_3$ should be more ductile than $\alpha$-$Al_2O_3$ formed totally or partially as a result of the phase transformation and even more ductile than $\kappa$-$Al_2O_3$, the plasticity of which is limited by the defect structure.

However, the stable $\alpha$-$Al_2O_3$ phase has been found to be more difficult to be nucleated and grown at reasonable CVD temperatures than the metastable $\kappa$-$Al_2O_3$. It has been experimentally confirmed that $\alpha$-$Al_2O_3$ can be nucleated, for example, on $Ti_2O_3$ surfaces, bonding layers of (Ti,Al)(C,O) as shown in US 5,137,774 or by controlling the oxidation potential using $CO/CO_2$ mixtures as shown in US 5,654,035. The bottom line in all these approaches is that nucleation must not take place on the 111-surfaces of TiC, TiN, Ti(C,N) or Ti(C,O,N), otherwise $\kappa$-$Al_2O_3$ is obtained.

It should also be noted that in prior art methods higher deposition temperatures are usually used to deposit $\alpha$-$Al_2O_3$. When the nucleation control is not complete, as is the case in many prior art products, the produced $\alpha$-$Al_2O_3$ layers have, at least partly, been formed as a result of the $\kappa$-$Al_2O_3\rightarrow\alpha$-$Al_2O_3$ phase transformation. This is especially the case when thick $Al_2O_3$ layers are considered. These kind of $\alpha$-$Al_2O_3$ layers are composed of larger grains with transformation cracks. These coatings exhibit much lower mechanical strength and ductility than the $\alpha$-$Al_2O_3$ coatings that are composed of nucleated $\alpha$-$Al_2O_3$.

Prior art

The control of the $\alpha$-$Al_2O_3$ polymorph in industrial scale was achieved in the beginning of the 1990's with commercial products based on US patent 5,137,774. Later modifications of this patent have been used to deposit $\alpha$-$Al_2O_3$ with preferred coating textures. In US 5,654,035 an alumina layer textured in the (012) direction and in US 5,980,988 in the (110) direction are disclosed. In US 5,863,640 a preferred growth either along (012), or (104) or (110) is disclosed. US 6,333,103 describes a modified method to control the nucleation and growth of $\alpha$-$Al_2O_3$ along the (10 (10)) direction.

Objects of the invention

It is an object of the present invention is to provide a new, improved alumina layer where the $\alpha$-$Al_2O_3$ phase consists of nucleated $\alpha$-$Al_2O_3$ with a strong, fully controlled (112) growth texture.

It has been surprisingly found that $\alpha$-$Al_2O_3$ layers having a strong, fully controlled (112) growth texture outperform the prior art with random or other textures such as (011). The coating according the present invention is essentially free from transformation stresses, consisting of columnar, $\alpha$-$Al_2O_3$ grains with low dislocation density and with improved cutting properties.

A method has been found to control the nucleation step of $\alpha$-$Al_2O_3$ so that a strong (012)-texture can be obtained. The invention is characterised by the dominating presence of (012) TC and simultaneous absence of the other common TCs typically found in the prior art coatings.

This kind of a $Al_2O_3$layer is especially intended to be used in toughness demanding steel application such as interrupted cutting, turning with coolant and especially intermittent turning with coolant. The other area is cast iron where the edge strength of this kind of alumina layer is superior to the prior art.

Before $\alpha$-Al$_2$O$_3$ is deposited on a Ti(C,N) coating which ca be obtained either by conventional CVD or MTCVD, preferably MTCVD, several steps are needed. First, on the Ti(C,N) layer a modified bonding layer described in US 5,137,774 (referred to as kappa-bonding in this patent) is deposited characterised by the presence of an Al concentration gradient. In addition, nitrogen gas is applied during deposition of this bonding layer. The aluminium content on the surface of this layer being considerably, about 30%, higher than in the bonding layer according to 5,137,774 and the bonding layer is obviously containing nitrogen. The surface of this bonding layer is subjected to an additional treatment(s) using a AlCl$_3$/H$_2$ gas mixture in order to increase further the aluminium content. After this a carefully controlled oxidation treatment is performed using a CO$_2$/H$_2$ gas mixture. The oxidation step is short and may be followed by a short treatment with a AlCl$_3$/H$_2$ mixture, again followed by a short oxidisation step. This kind of pulsating (Al-treatments/oxidisation) treatments will create favourable nucleation sites for $\alpha$-Al$_2$O$_3$. The growth of the alumina layer onto the surface modified bonding layer is started by sequencing the reactant gases in the following order: CO, AlCl$_3$, CO$_2$. The temperature shall preferably be about 1000 °C.

The present invention also relates to a cutting tool insert consisting of a substrate at least partially coated with a coating with a total thickness of 10-40 μm, preferably 15-25 μm consisting of one or more refractory layers of which at least one layer is an alpha alumina layer. This $\alpha$-Al$_2$O$_3$ layer is dense and defect-free. It is composed of columnar grains with a strong (012) texture. The columnar grains have a length/width ratio of from 2 to 12, preferably 5 to 9 with a width of 0.5-2.5 μm, preferably 0.5-1.0 (s=2-5μm) or 1.5-2.5 (s=5-15μm). S= the total thickness of the alumina layer.

The texture coefficients (TC) for the $\alpha$-Al$_2$O$_3$ according to this invention layer is determined as follows:

$$TC(hkl) = \frac{I(hkl)}{I_0(hkl)} \left\{ \frac{1}{n} \sum \frac{I(hkl)}{I_0(hkl)} \right\}^{-1}$$

where

I(hkl) = intensity of the (hkl) reflection
I$_0$(hkl) = standard intensity according to JCPDS card no 46-1212
n = number of reflections used in the calculation (hkl) reflections used are: (012), (104), (110), (113), (024), (116).

The texture of the alumina layer is defined as follows:
    TC(012) > 1.8, TC(024) > 1.8, preferably 2.5-3.5 and simultaneously TC(104), TC(110), TC(113), TC(116) < 0.4, preferably < 0.3.

It is noted that the intensities of the planes 012 and 024 are related.

The substrate comprises a hard material such as cemented carbide, cermets, ceramics, high speed steel or a superhard material such as cubic boron nitride (CBN) or diamond preferably cemented carbide or CBN. With CBN is herein meant a cutting tool material containing at least 40 vol-% CBN. In a preferred embodiment the substrate is a cemented carbide with a binder phase enriched surface zone.

The coating comprises a first layer adjacent the body of CVD Ti(C,N), CVD TiN, CVD TiC, MTCVD Ti(C,N), MTCVD Zr(C,N), MTCVD Ti(B,C,N), CVD HfN or combinations thereof preferably of Ti(C,N) having a thickness of from 1 to 20 μm, preferably from 1 to 10 μm and said $\alpha$-Al$_2$O$_3$ layer adjacent said first layer having a thickness of from about 1 to 40 μm, preferably from 1 to 20 μm, most preferably from 1 to 10 μm. Preferably there is an intermediate layer of TiN between the substrate and said first layer with a thickness of <3 μm, preferably 0.5-2 μm.

In one embodiment the $\alpha$-Al$_2$O$_3$ layer is the uppermost layer

In another embodiment there is a layer of carbide, nitride, carbonitride or carboxynitride of one or more of Ti, Zr and Hf, having a thickness of from about 0.5 to 3 μm, preferably 0.5 to 1.5 μm atop the $\alpha$-Al$_2$O$_3$ layer. Alternatively this layer has a thickness of from about 1 to 20 μm, preferably 2 to 8 μm.

In yet another embodiment the coating includes a layer of $\kappa$-Al$_2$O$_3$ and/or $\gamma$-Al$_2$O$_3$ preferably atop the $\alpha$-Al$_2$O$_3$. with a thickness of from 0.5 to 10, preferably from 1 to 5 μm.

Example 1

Cemented carbide cutting inserts with a composition of 5.9% Co and balance WC (hardness about 1600 HV) were coated with a layer of MTCVD Ti(C,N). The thickness of the MTCVD layer was about 8 μm. On to this layer 8 μm

$\alpha$-Al$_2$O$_3$ was deposited a) according to the present invention as defined below and b) according to the prior art. The inserts were studied by using XRD and the texture coefficients were determined. Table 1 shows the texture coefficients for the coating according to this invention and for the prior art coating. As can be seen a strong (012) texture is obtained according to this invention.

Table 1.

| Hkl | Invention (coating a) | Prior art (coating b) |
|-----|----------------------|----------------------|
| 012 | 2.79 | 0.72 |
| 104 | 0.05 | 0.64 |
| 110 | 0.19 | 1.63 |
| 113 | 0.07 | 0.87 |
| 024 | 3.26 | 1.16 |
| 116 | 0.15 | 0.97 |

Deposition process of "**Coating a**" (invention) is specified in the following:

| Step 1: MTCVD coating | | |
|---|---|---|
| Gas mixture | TiCl$_4$<br>CH$_3$CN<br>N$_2$<br>Balance: | = 4.0%<br>= 1.0%<br>= 20%<br>H$_2$ |
| Duration<br>Temperature<br>Pressure | 250 min<br>850 °C<br>100 mbar | |

| Step 2: Bonding layer | | |
|---|---|---|
| Gas mixture | TiCl$_4$<br>AlCl$_3$<br>CO<br>CO$_2$<br>N$_2$<br>Balance: | = 2.8%<br>= 0.8 - 4.2%<br>= 5.8%<br>= 2.2 %<br>= 5-6%<br>H$_2$ |
| Duration | | 60 min |
| Temperature | | 1000 °C |
| Pressure | | 100 mbar |

| Step 3: Aluminising step | | |
|---|---|---|
| Gas mixture | AlCl$_3$<br>Balance: | = 0.8 -4.2%<br>H$_2$ |
| Duration<br>Temperature<br>Pressure | 15 min or<br>1000 C<br>50 mbar | 2 min pulsating |

| Step 4: Oxidising step | | |
|---|---|---|
| Gas mixture | $CO_2$<br>Balance: | = 0.1%<br>$H_2$ |
| Duration<br>Temperature<br>Pressure | 2 min or 20 s pulsating<br>1000 C<br>100 mbar | |

| Step 5: Nucleation step | | |
|---|---|---|
| Gas mixture | $AlCl_3$<br>HCL<br>$CO_2$<br>Balance | = 3,2 %<br>= 2.0 %<br>= 1.9 %<br>$H_2$ |
| Duration<br>Temperature<br>Pressure | 60 min<br>1000 °C<br>210 mbar | |

| Step 6: Deposition | | |
|---|---|---|
| Gas mixture | $AlCl_3$<br>HCL<br>$CO_2$<br>$H_2S$<br>Balance: | = 4.2 %<br>= 1.0 %<br>= 2.1%<br>= 0.2%<br>$H_2$ |
| Duration<br>Temperature<br>Pressure | 420 min<br>1000 °C<br>50 mbar | |

Example 2

The coatings a) and b) from the example 1 were tested with respect to edge toughness in longitudinal turning.

| Work piece: | Cylindrical bar |
|---|---|
| Material: | SS0130 |
| Insert type: | SNUN |
| Cutting speed: | 400 m/min |
| Feed: | 0.4 mm/rev |
| Depth of cut: | 2.5 mm |
| Remarks: | dry turning |

The inserts were inspected after 2 and 4 minutes of cutting. As clear from Table 2 the edge toughness of the prior art product was considerably enhanced when the coating was produced according to this invention.

Table 2

| | Flaking of the edge line (%) after 2 minutes | Flaking of the edge line (%) After 6 minutes |
|---|---|---|
| Coating a (Invention) | 0 | <1 |
| Coating b | 38 | 62 |

Example 3

The coating produced according to this invention was compared with a market leader, referred here as Competitor X. This coating is composed of MTCVD Ti(C,N) and $\alpha$-Al$_2$O$_3$. XRD was used to determine the texture coefficients for these competitor coatings. Two inserts from Competitor X were randomly chosen for XRD. Table 3 shows the obtained TCs for the Competitor X. The coatings from Competitor X exhibit a (110) texture.

Table 3

| Hkl | TC(hkl) | |
|-----|------|------|
| 012 | 0.64 | 0.59 |
| 104 | 0.95 | 0.88 |
| 110 | 1.75 | 2.00 |
| 113 | 0.45 | 0.42 |
| 024 | 1.15 | 1.10 |
| 116 | 1.07 | 1.01 |

Example 4

The inserts from the competitor X were compared with inserts produced according to the present invention with the same substrate composition and the same coating structure. Before the tests the both inserts produced according to this invention were X-rayed. The strong (012) texture was confirmed.
Two inserts produced according to this invention were compared with the two Competitor X inserts with respect to flank wear resistance in face turning of ball bearing material

| Work piece | Cylindrical tubes(Ball bearings) |
|-----|-----|
| Material | SS2258 |
| Insert type | WNMG080416 |
| Cutting speed | 500 m/min |
| Feed | 0.5 mm/rev |
| Depth of cut | 1.0 mm |
| Remarks | Dry turning |
| Tool life criterion | Flank wear > 0.3 mm, three edges of each variant were tested. |

| Results : | Tool life (min) |
|-----|-----|
| Coating 1 | 22 (invention) |
| Coating 2 | 23.5 (invention) |
| Competitor 1 | 15.5 (prior art) |
| Competitor 2 | 13 (prior art) |

Example 5

Cubic boron nitride (CBN) insert containing about 90 % of polycrystalline CBN (PCBN) were coated according to this invention and according to prior art coating discussed in Example1. The coated CBN was compared with uncoated CBN insert in cutting of steel containing ferrite. It is known that B has a high affinity to ferrite and diffusion wear occurs at high cutting speeds.

| Work piece | Cylindrical bar |
|-----|-----|
| Material | SS0130 |
| Insert type | SNUN |
| Cutting speed | 860 m/min |
| Feed | 0.4 mm/rev |

(continued)

| Depth of cut | 2.5 mm |
|---|---|
| Remarks | dry turning |

| Results | |
|---|---|
| | Life time (min) |
| Coated CBN (Invention) | 22 |
| Coated according to prior art | 14 |
| Uncoated CBN | 11 |

**Claims**

1. Cutting tool insert consisting of a substrate at least partially coated with a coating with a total thickness of 10-40 μm, preferably 15-25 μm consisting of one or more refractory layers of which at least one layer is an alumina layer **characterized in** said alumina layer being composed of columnar $\alpha$-Al$_2$O$_3$ grains with texture coefficients

   a) TC(012) and TC(024) both >1.8 preferably 2.5 -3.5 and
   b) TC(104), TC(110), TC(113), TC(116) all< 0.4, preferably <0.3.

   The texture coefficient TC(hkl) being defined as

   $$TC(hkl) = \frac{I(hkl)}{I_O(hkl)} \left\{ \frac{1}{n} \sum \frac{I(hkl)}{I_O(hkl)} \right\}^{-1}$$

   where

   I(hkl) = measured intensity of the (hkl) reflection
   I$_o$(hkl) = standard intensity according to JCPDS card no 46-1212
   n = number of reflections used in the calculation
   (hkl) reflections used are: (012), (104), (110), (113), (024), (116).

2. Cutting tool insert according to claim 1 **characterized in** said alumina layer being composed of columnar grains with the length/width ratio from 2 to 12, preferably 5 to 9.

3. Cutting tool insert according to any of the previous claims **characterized in that** said substrate comprises cemented carbide, CBN or sintered CBN alloy.

4. Cutting tool insert according to any of the previous claims **characterized in that** the coating comprises a first layer adjacent the body of CVD Ti(C,N), CVD TiN, CVD TiC, MTCVD Ti(C,N), MTCVD Zr(C,N), MTCVD Ti(B,C.N), CVD HfN or combinations thereof preferably of Ti(C,N) having a thickness of from 1 to 20 μm, preferably from 1 to 10 μm and said $\alpha$-Al$_2$O$_3$ layer adjacent said first layer having a thickness of from about 1 to 40 μm, preferably from 1 to 20 μm, most preferably from 1 to 10 μm.

5. Cutting tool insert according to any of the previous claims **characterized in that** the $\alpha$-Al$_2$O$_3$ layer is the uppermost layer

6. Cutting tool insert according to any of the previous claims **characterized in that** a layer of carbide, nitride, carbonitride or carboxynitride of one or more of Ti, Zr and Hf, having a thickness of from about 0.5 to 3 μm, preferably 0.5 to 1.5 μm atop the $\alpha$-Al$_2$O$_3$ layer.

7.   Cutting tool insert according to any of claims 1-6 **characterized in** a layer of carbide, nitride, carbonitride or carboxynitride of one or more of Ti, Zr and Hf, having a thickness of from about 1 to 20 $\mu$m, preferably 2 to 8 $\mu$m atop the $\alpha$-Al$_2$O$_3$ layer.

8.   Cutting tool insert according to any of the previous claims **characterized in** a layer of $\kappa$-Al$_2$O$_3$ or $\gamma$-Al$_2$O$_3$ atop the $\alpha$-Al$_2$O$_3$. with a thickness of from 0.5 to 10, preferably from 1 to 5 $\mu$m.

9.   Cutting tool insert according to any of the previous claims **characterized in** a layer of TiN between the substrate and said first layer with a thickness of <3 $\mu$m, preferably 0.5-2 $\mu$m.

10.  Cutting tool insert according to any of the previous claims **characterized in that** said substrate comprises a cemented carbide with a binder phase enriched surface zone.

11.  Method of making an $\alpha$-Al$_2$O$_3$ layer according to claim 1 **characterized in that** nucleation of said $\alpha$-Al$_2$O$_3$ is obtained by modification of the nucleation surface by aluminising and oxidising steps and that the said nucleation surface is a bonding layer of (Ti,Al)(C,O,N) with increasing aluminium content towards the nucleation surface.

**EP 1 477 581 A1**

**European Patent Office**

## EUROPEAN SEARCH REPORT

Application Number

EP 03 01 0542

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 247 789 A (SANDVIK AB) 9 October 2002 (2002-10-09) * paragraph [0016]; claims 3,5; figures 2,4; example 1 * | 1-7,9,10 | C23C16/40 C23C30/00 C23C28/04 C23C16/02 B23B27/14 |
| Y | | 8,11 | |
| Y | US 2001/006724 A1 (HOLZSCHUH HELGA) 5 July 2001 (2001-07-05) * paragraphs [0024], [0025], [0030], [0043] - [0049]; figure 3; example 1 * | 8,11 | |
| A | WO 98/10119 A (SANDVIK AB) 12 March 1998 (1998-03-12) * page 2, line 18 - page 4, line 13 * | 1-10 | |
| D,A | EP 0 603 144 A (SANDVIK AB) 22 June 1994 (1994-06-22) * example 1 * | 1-10 | |
| A | PATENT ABSTRACTS OF JAPAN vol. 0041, no. 55 (C-029), 29 October 1980 (1980-10-29) & JP 55 100978 A (MITSUBISHI METAL CORP), 1 August 1980 (1980-08-01) * abstract * | 11 | TECHNICAL FIELDS SEARCHED (Int.Cl.7) C23C B23B |

The present search report has been drawn up for all claims

| Place of search | Date of completion of the search | Examiner |
|---|---|---|
| Munich | 12 March 2004 | Hoyer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

9

# EP 1 477 581 A1

**ANNEX TO THE EUROPEAN SEARCH REPORT
ON EUROPEAN PATENT APPLICATION NO.**                    EP 03 01 0542

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2004

| Patent document cited in search report | | Publication date | Patent family member(s) | | Publication date |
|---|---|---|---|---|---|
| EP 1247789 | A | 09-10-2002 | SE | 522736 C2 | 02-03-2004 |
| | | | EP | 1247789 A2 | 09-10-2002 |
| | | | JP | 2002263914 A | 17-09-2002 |
| | | | SE | 0100520 A | 17-08-2002 |
| | | | US | 2002155325 A1 | 24-10-2002 |
| US 2001006724 | A1 | 05-07-2001 | DE | 19962056 A1 | 12-07-2001 |
| | | | EP | 1113092 A2 | 04-07-2001 |
| | | | JP | 2001219307 A | 14-08-2001 |
| WO 9810119 | A | 12-03-1998 | SE | 509560 C2 | 08-02-1999 |
| | | | AT | 231192 T | 15-02-2003 |
| | | | CN | 1229442 A ,B | 22-09-1999 |
| | | | DE | 69718517 D1 | 20-02-2003 |
| | | | DE | 69718517 T2 | 07-08-2003 |
| | | | EP | 0953065 A1 | 03-11-1999 |
| | | | IL | 128360 A | 31-10-2001 |
| | | | JP | 2000517252 T | 26-12-2000 |
| | | | SE | 9603264 A | 07-03-1998 |
| | | | WO | 9810119 A1 | 12-03-1998 |
| | | | US | 5945207 A | 31-08-1999 |
| EP 0603144 | A | 22-06-1994 | SE | 501527 C2 | 06-03-1995 |
| | | | AT | 145437 T | 15-12-1996 |
| | | | BR | 9305108 A | 21-06-1994 |
| | | | CN | 1091683 A ,B | 07-09-1994 |
| | | | DE | 69306089 D1 | 02-01-1997 |
| | | | DE | 69306089 T2 | 13-03-1997 |
| | | | EP | 0603144 A1 | 22-06-1994 |
| | | | IL | 107977 A | 14-08-1997 |
| | | | JP | 3325987 B2 | 17-09-2002 |
| | | | JP | 6316758 A | 15-11-1994 |
| | | | RU | 2117074 C1 | 10-08-1998 |
| | | | SE | 9203852 A | 19-06-1994 |
| | | | US | 5487625 A | 30-01-1996 |
| | | | US | 5654035 A | 05-08-1997 |
| JP 55100978 | A | 01-08-1980 | JP | 1279698 C | 29-08-1985 |
| | | | JP | 59045755 B | 08-11-1984 |

For more details about this annex : see Official Journal of the European Patent Office, No. 12/82